(19) **Europäisches Patentamt**
**European Patent Office**
**Office européen des brevets**

(11) **EP 1 665 533 B1**

(12) **EUROPEAN PATENT SPECIFICATION**

(45) Date of publication and mention
of the grant of the patent:
**20.08.2008 Bulletin 2008/34**

(51) Int Cl.:
*H03K 9/00* (2006.01)     *H04L 27/06* (2006.01)

(21) Application number: **03754845.0**

(86) International application number:
**PCT/US2003/029949**

(22) Date of filing: **25.09.2003**

(87) International publication number:
**WO 2005/041408 (06.05.2005 Gazette 2005/18)**

(54) **DIGITAL RF TRANSCEIVER WITH MULTIPLE IMAGING MODES**

DIGITAL-HF-SENDER/-EMPFÄNGER MIT MEHREREN ABBILDUNGSBETRIEBSARTEN

EMETTEUR/RECEPTEUR RF NUMERIQUE AVEC MODES D'IMAGERIE MULTIPLES

(84) Designated Contracting States:
**DE ES FR GB IT**

(43) Date of publication of application:
**07.06.2006 Bulletin 2006/23**

(73) Proprietor: **Thomson Licensing
92100 Boulogne-Billancourt (FR)**

(72) Inventor: **MCNEELY, David, Lowell
Indianapolis, IN 46256 (US)**

(74) Representative: **Le Dantec, Claude
46, Quai Alphonse Le Gallo
92100 Boulogne-Billancourt (FR)**

(56) References cited:
**EP-A- 0 817 369       EP-A- 0 999 645
WO-A-97/30521       WO-A-03/069772
US-A- 5 473 280       US-B1- 6 347 123
US-B1- 6 359 938**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to processing orthogonal frequency division multiplexed (OFDM) signals.

BACKGROUND OF THE INVENTION

This section is intended to introduce the reader to various aspects of art which may be related to various aspects of the present invention which are described and/or claimed below. This discussion is believed to be helpful in providing the reader with background information to facilitate a better understanding of the various aspects of the present invention. Accordingly, it should be understood that these statements are to be read in this light, and not as admissions of prior art.

A wireless LAN (WLAN) is a flexible data communications system implemented as an alternative or extension to a wired LAN within a building or campus. Using electromagnetic waves, WLANs transmit and receive data over the air, minimizing the need for wired connections. Thus, WLANs combine data connectivity with user mobility, and, through simplified configuration, enable movable LANs. Some industries that have benefited from the productivity gains of using portable terminals (e.g., notebook computers) to transmit and receive real-time information are the digital home networking, health-care, retail, manufacturing, and warehousing industries.

Manufacturers of WLANs have a range of transmission technologies to choose from when designing a WLAN. Some exemplary technologies are multicarrier systems, spread spectrum systems, narrowband systems, and infrared systems. Although each system has its own benefits and detriments, one particular type of multicarrier transmission system, orthogonal frequency division multiplexing (OFDM), has proven to be exceptionally useful for WLAN communications.

OFDM is a robust technique for efficiently transmitting data over a channel. The technique uses a plurality of sub-carrier frequencies (sub-carriers) within a channel bandwidth to transmit data. These sub-carriers are arranged for optimal bandwidth efficiency compared to conventional frequency division multiplexing (FDM) which can waste portions of the channel bandwidth in order to separate and isolate the sub-carrier frequency spectra and thereby avoid inter-carrier interference (ICI). By contrast, although the frequency spectra of OFDM sub-carriers overlap significantly within the OFDM channel bandwidth, OFDM nonetheless allows resolution and recovery of the information that has been modulated onto each sub-carrier.

The transmission of data through a channel via OFDM signals also provides several other advantages over more conventional transmission techniques. Some of these advantages are a tolerance to multipath delay spread and frequency selective fading, efficient spectrum usage, simplified sub-channel equalization, and good interference properties.

In spite of these advantages, there are some problems with OFDM data transfer. An OFDM System generates base band symbols via a Fast Fourier Transform (FFT) that consist of many samples. The base band signal so constructed is complex (a real component and an imaginary component) and has a complex frequency content approximating (though less than), half the sampling frequency. The modulation of the base band sample data signal and subsequent demodulation of a sampled data radio frequency (RF) signal is a relatively complex process.

Known methods of digital modulation include separately up-sampling the real and imaginary components with a sample rate converter (filtering process) from a base band sampling rate, $S_0$, to a sampling rate, $S_1$, sufficient to carry the base band signal modulated on the desired carrier. The desired sample data complex carrier may be created at the sampling rate $S_1$. The real part of the base band signal is multiplied with the real part of the complex carrier (cosine) and added to the product of the imaginary part of the base band signal with the imaginary part of the complex carrier (sine) to create a real sample data RF signal. A compensated digital-to-analog (D/A) converter converts the real sample data RF signal to an analog RF signal.

Circuits for generating a signal from a sampled signal using interpolation and filtering are known and have been described in EP-A-0 999 645 (Motorola) and EP--A 0 817 369 (Harris Corp).

If a first modulation to a carrier of frequency $f_0$ has been performed and a carrier of frequency $f_1$ is desired, there are two conventional continuations. If the first modulated signal is in complex form (cosine and sine components have not been added), then the signal may be treated as a base band signal as above. A second modulation with a complex carrier of $(f_1-f_0)$ will yield the desired result. If the first modulated signal is in real form, one can first regenerate a complex form (typically involving Hilbert filtering) and then continue as set forth above.

Alternatively, if the first modulated signal is in real form, one can perform a second real modulation $((f_1-f_0)$ cosine) and filter out undesired images that are created. If this is done, undesirable images may be created. A method and apparatus that reduces the complexity of supporting two modulation modes is desirable.

## SUMMARY OF THE INVENTION

The disclosed embodiments relate to a digital radio frequency (RF) circuit that creates a signal in a desired range in a frequency spectrum. The RF circuit comprises circuitry that produces a first sample data modulated signal having a first frequency and a first sample data clock rate. An up-sampler modulator receives the first sample data modulated signal and produces a second sample data modulated signal having a second frequency and a second sample data clock rate. The RF circuit may also comprise circuitry that receives the first sample data modulated signal and the second sample data modulated signal and delivers one of the first sample data modulated signal and the second sample data modulated signal for further processing depending on which sample data modulated signal exhibits desirable characteristics for a given operating environment.

## BRIEF DESCRIPTION OF THE DRAWINGS

In the drawings:

FIG. 1 is a block diagram of an exemplary OFDM transceiver in which the present invention may be employed;
FIG. 2 is a block diagram of a transceiver circuit according to an embodiment of the present invention; and
FIG. 3 is a block diagram of an up-sampler modulator in accordance with an embodiment of the present invention.

## DETAILED DESCRIPTION OF THE PREFERRED EMBODIMENT

One or more specific embodiments of the present invention will be described below. In an effort to provide a concise description of these embodiments, not all features of an actual implementation are described in the specification. It should be appreciated that in the development of any such actual implementation, as in any engineering or design project, numerous implementation-specific decisions may be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

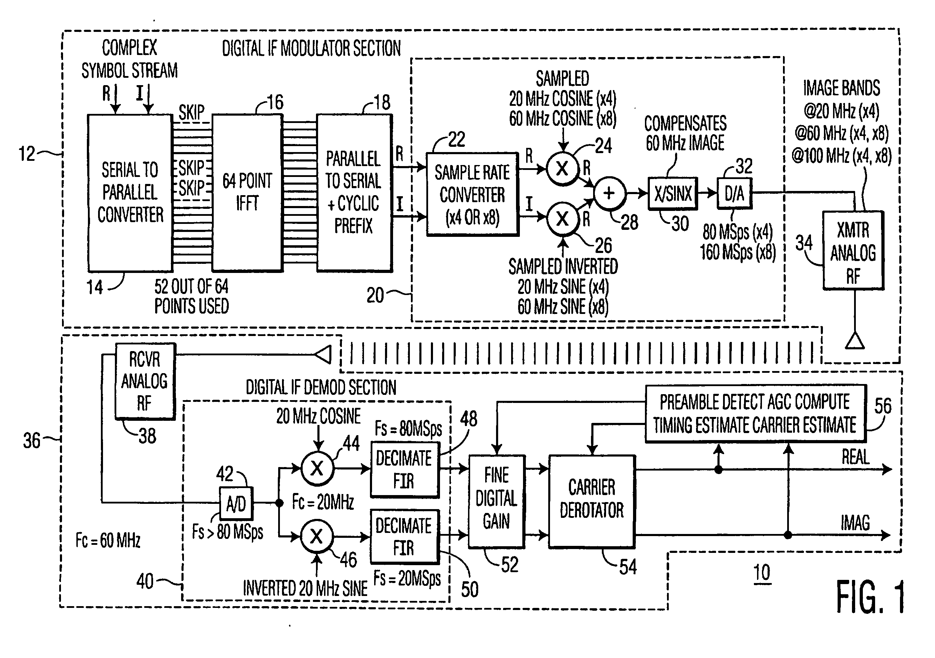

FIG. 1 is a block diagram of an exemplary OFDM transceiver according to an embodiment of the present invention. The transceiver is generally referred to by the reference numeral 10. The transceiver 10 comprises a transmitter portion 12 (shown in dashed lines) and a receiver portion 36 (shown in dashed lines.

The transmitter portion 12 comprises a serial-to-parallel converter 14, which receives a complex symbol stream. The serial-to-parallel converter 14 delivers its output to a 64-point inverse fast Fourier transform (IFFT) circuit 16, which translates the parallelized complex symbol stream from the frequency domain into the time domain. The IFFT circuit 16 delivers its output to a parallel to serial conversion circuit 18, which may also include the capability of generating cyclic prefix information for use in subsequent transmission of a signal. The parallel to serial conversion circuit 18 delivers real and imaginary signal components to a digital intermediate frequency (IF) modulator section 20.

The digital IF modulator section 20 comprises a sample rate converter 22. The sample rate converter upsamples its sample data inputs (first sample rate = 20 MSps for illustration) to a higher second sample rate. In principle this second sample rate could be arbitrary selected with appropriate down stream accommodation. Two specific upsampling ratios are referenced: an upsampling by 4 (x4) and an upsampling by 8 (x8). The corresponding post Sample Rate Converter Sample Rates are 80 MSps (20MSps x 4 and, 160 MSps ( 20 MSps x 8). If an upsampling by 4 (x4) was performed, the sampled data of a 60 MHz cosine/sine carrier at an 80 MSps (4 x 20 MSps) rate is identical to the samples of a 20 MHz cosine/sine at an 80 MSps rate. The real component output of the sample rate converter 22 is delivered to a multiplier 24, which multiplies the real component by a sample data 20 MHz cosine signal (for x4 sampling) or a sample data 60 MHz cosine signal (for x8 sampling). The imaginary component output of the sample rate converter 22 is delivered to a multiplier 26, which multiplies the imaginary component by an inverted 20 MHz sine signal (for 4x sampling) or a non-inverted 60 MHz sine signal (for 8x sampling). The sign of the sine carrier compensates for spectral inversion that otherwise occurs due to an odd number of Nyquist folds of a sampled supported spectrum (ex. about 20 MHz @ 80 MSps) into a image about a desired carrier (about 60 MHz which folds with inversion onto 20 MHz from second "panel" of Nyquist folding frequency (80 MSps/2 ) spaced segmentation of frequency.

The outputs of the multipliers 24 and 26 are delivered to a summing circuit 28. The output of the summing circuit 28 is delivered to an x/sinx circuit 30, which compensates the desired post-D/A 60 MHz image. The output of the x/sinx circuit 30 is delivered to a D/A converter 32. The output of the D/A converter 32 is delivered to a transmitter, which transmits the signal.

In an exemplary embodiment of the present invention, the RF signal carrier of the pre-D/A sample data has a frequency equal to the D/A clock rate divided by four (4). The post-D/A analog RF signal carrier is three-fourths (3/4) of the D/A clock rate. Images at the clock rate divided by 4 and at five-fourths (5/4) of the clock rate (and above) are removed by analog filtering. Choice of another image as the desired RF signal merely requires choice of the appropriate sign of the sin modulator. There are different gains for different images due to the D/A filter response, which must be accommodated via downstream analog processing.

The receiver portion 36 comprises a receiver 38, which receives transmitted RF OFDM signals. The received signal is delivered to a digital IF demodulation section 40 for further processing. The digital IF demodulation section 40 comprises an analog-to-digital (A/D) converter 42, which breaks the received signal into constituent real and imaginary components. The real component is delivered to a multiplier 44, which multiplies it by a 20 MHz cosine signal and delivers the result to a decimate finite impulse response filter (FIR) 48. The imaginary component of the output of the A/D converter 42 is delivered to a multiplier 46, which multiplies it by an inverted 20 MHz sine signal and delivers the result to a decimate FIR filter 50.

The conventional process of digital demodulation is to A/D convert a real signal at a sufficient sample rate to preserve the modulation. In accordance with embodiments of the present invention, a 60 MHz intermediate frequency (IF) signal is sampled at 80 million samples per second (MSps) with a sample and hold circuit with a narrow aperture. This held sample is A/D converted to an 8-bit integer number. The 60 MHz IF pre-A/D signal appears as a post-A/D 20 MHz IF signal due to spectral folding. The real signal is multiplied by a complex exponential matching the frequency of the RF carrier or, in the case of the exemplary embodiment shown in FIG. 1, a folded version of the RF carrier. This will create an over-sampled complex base band signal, which is anti-alias filtered and sub-sampled to the OFDM FFT rate.

The outputs of the FIR filters 48 and 50 are delivered to a fine digital gain circuit 52. The output of the fine digital gain circuit 52 is delivered to a carrier derotator 54, which delivers real and imaginary data components for further processing. The real and imaginary components are additionally provided to a feedback circuit 56, which may provide preamble detection, automatic gain control (AGC) computation, timing estimation and carrier estimation functionality. The output of the feedback circuit 56 is provided to the carrier derotator 54 and the fine digital gain circuit 52.

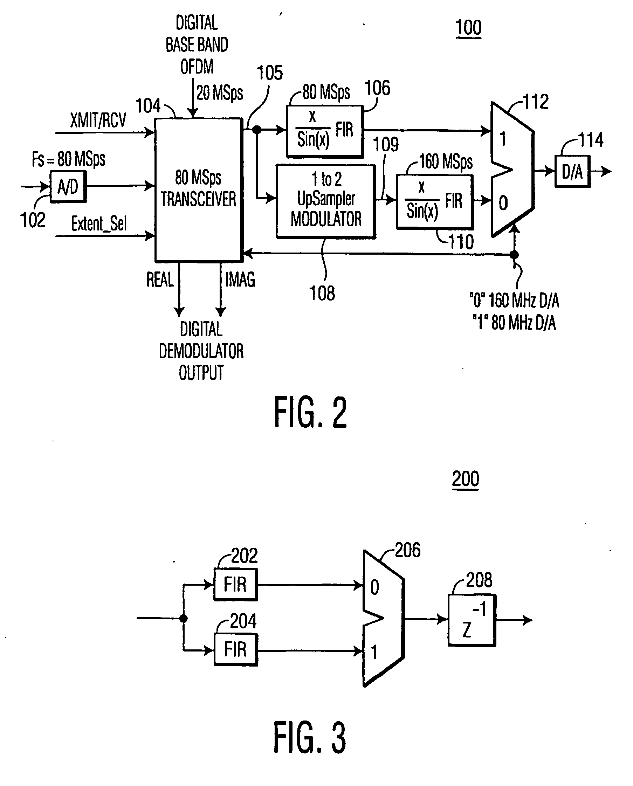

FIG. 2 is a block diagram of a transceiver circuit according to an embodiment of the present invention wherein a multi-imaging mode feature (160 MSps, 60 MHz IF) is added to a transceiver utilizing a single imaging mode (corresponding to the 80 MSps 60 MHz IF mode shown in FIG. 1). The transceiver circuit is generally referred to by the reference numeral 100. The transceiver circuit 100 may perform the functions of the digital IF modulator section 20 (FIG. 1) and the digital IF demodulator section 40 (FIG. 1).

The transceiver circuit 100 supports two different D/A clock rates. The low clock rate is used to generate an IF signal in a frequency band higher than the Nyquist folding frequency. The high clock rate is used to generate an IF signal in the same frequency band but not lower than the now higher Nyquist folding frequency. Susceptibility to non-linear effects of the D/A and self interference as well as electromagnetic interference ("EMI") effects are different between the two clock modes.

The use of two clock modes in accordance with the present invention may result in a number of advantages. One advantage is that power consumption savings may be obtained by using the lower clock rate circuitry without the need to replicate circuitry. Another advantage is that EMI emissions are different for the two modes of operation. This gives system designers flexibility to choose whichever mode of operation is most compatible with a desired EMI profile. A third advantage is that dynamic range (analog resolution) of the inchannel IF signal for the low clock rate mode is the same as the dynamic range of the inchannel IF signal for the high clock rate mode, even though the signal levels are different.

Those of ordinary skill in the art will appreciate that the proportion of D/A output energy in channel is reduced in the lower clock rate signal and additional analog filtering is required to eliminate an undesired image. Additional analog amplification may be needed for the low clock rate signal if the analog IF signal is noise limited.

Before transmission, the output of the D/A converter 32 (e.g., the IF signal) may travel through additional analog RF circuitry (not shown), which converts the IF signal to an RF signal. The RF signal undergoes impairments of multipath, attenuation, and adjacent channel interference. Meeting a desired specification for a given product relates to this processing chain. Anticipated operating conditions for an IF transmitter may be such that only one operational mode (low clock mode or high clock mode) may be needed for a given application. One could envision using dual mode operation in the same product in a number of scenarios to provide a benefit based on anticipated operating conditions (for example, multi-mode RF post processing, or to allow extra broadcast image if an area of a particular spectrum is not in use).

An A/D converter 102, which may correspond to the A/D converter 42 (FIG. 1), receives an input that may correspond to a received analog OFDM RF signal. The A/D converter 102 delivers its output to an 80 MSps transceiver 104. The 80 MSps transceiver 104 receives a transmit/receive select signal and an extent select signal. A digital base band OFDM signal is also delivered to the 80 MSps transceiver. The 80 MSps transceiver 104 delivers real and imaginary output components as its digital demodulator output.

The 80 MSps transceiver 104 delivers a first sample data modulated signal 105 to an 80 MSps x/sin(x) finite impulse response (FIR) filter 106 and a 1-to-2 up-sampler modulator 108. Although a 1-to-2 up-sampler is illustrated in the embodiment disclosed in FIG. 2, those of ordinary skill in the art will appreciate that up-samplers having other ratios may be used. The 1-to-2 up-sampler modulator 108 delivers a second sample data modulated signal 109 to a 160 MSps x/sin(x) FIR filter 110. The output of the 80 MSps x/sin(x) finite impulse response (FIR) filter 106 and the 160 MSps x/sin(x) FIR filter 110 are delivered as separate inputs to a multiplexer 112. While a multiplexer is illustrated in FIG. 2, those of ordinary skill in the art will appreciate that the function of the multiplexer 112 may be performed by any circuitry that receives multiple inputs and selects one of those inputs as an output.

The multiplexer 112 receives a control input that determines whether transceiver D/A conversion is performed at 80 MSps or 160 MSps. The control signal is also delivered to the 80 MSps transceiver 104. The output of the multiplexer 112 is delivered to a D/A converter 114, which may correspond to the D/A converter 32 (FIG. 1).

In the 80 MSps transceiver 104, the real 80 MSps output (20 MHz carrier) will generate a 60 MHz signal when used with an 80 MSps D/A clock. If the D/A clock is 160 MSps then the 80 MSps transmitter output may be up-sampled to 160 MSps and the OFDM signal on a 20 MHz carrier is converted to a OFDM signal on a 60 MHz carrier.

FIG. 3 is a block diagram of an up-sampler modulator in accordance with an embodiment of the present invention. In FIG. 3, the up-sampler modulator is generally referred to by the reference numeral 200. The up-sampler modulator 200 may correspond to the 1-to-2 up-sampler modulator 108 (FIG. 2). The up-sampler modulator 200 takes the OFDM 20 MHz IF output of a transceiver (such as the 80 MSps transceiver 104 (FIG. 2)) and up-samples and modulates it to an OFDM 60 MHz IF signal at 160 MSps.

The input to the up-sampler modulator 200 is delivered to a FIR filter 202 and a FIR filter 204 in parallel. The outputs of the FIR filters 202 and 204 are delivered as inputs to a 2-to-1 multiplexer 206. The output of the 2-to-1 multiplexer 206 is delivered to a delay line 208. The tap coefficients of the FIR filters 202 and 204 may be expressed, respectively, as follows:

FIR filter 202:

$$\frac{-3 + 3 \cdot z^{-1} - 14 \cdot z^{-2} + 38 \cdot z^{-3} + 38 \cdot z^{-4} - 14 \cdot z^{-5} + 3 \cdot z^{-6} - 3 \cdot z^{-7}}{64},$$

where $z^{-1} \equiv$ one 80 MSps Sample Delay

FIR filter 204:

$$-\frac{65 \cdot z^{-3}}{64}$$

The Nyquist folding frequency of a 160 MSps is 80 MHz, which corresponds to the real sequence exp(j*pi*n) =cos(pi*n) in the sampled data domain. This modulation can be built in to an up-sampler modulator and will not generate any spurious images.

In the z-plane, the product of the real components of the base band OFDM signal and the complex carrier equate to a real signal at a first carrier frequency. When that signal is x2 up-sampled, the result equates to the product of the real components of the second real carrier and the first modulated signal re-sampled. That result equates to a digital RF signal at the difference of the two carriers.

While the invention may be susceptible to various modifications and alternative forms, specific embodiments have been shown by way of example in the drawings and will be described in detail herein. However, it should be understood that the invention is not intended to be limited to the particular forms disclosed. Rather, the invention is to cover all modifications, equivalents and alternatives falling within the scope of the invention as defined by the following appended claims.

**Claims**

1. A digital radio frequency (RF) circuit (100) that creates a signal in a desired range in a frequency spectrum, **characterized in that** it comprises:

   a circuit (104) that produces a first sample data modulated signal (105) having a first frequency and a first sample data clock rate;

an up-sampler modulator (108) that receives the first sample data modulated signal (105) and produces a second sample data modulated signal (109) having a second frequency and a second sample data clock rate; and a selector circuit-(112) that receives the first sample data modulated signal (105) and the second sample data modulated signal (109) and delivers one of the first sample data modulated signal (105) and the second sample data modulated signal (109) for further processing;

wherein the one of the first sample data modulated signal (105) and the second sample data modulated signal (109) is selected based on a characteristic of the digital RF circuit.

2. The RF circuit (100) set forth in claim 1, comprising a first filter (106) having first filter characteristics that receives the first sample data modulated signal (105) from the circuit (104) and a second filter (110) having second filter characteristics that receives the second sample data modulated signal (109) from the up-sampler modulator (108).

3. The RF circuit (100) set forth in claim 2, wherein at least one of the first filter (106) and the second filter (110) comprises a finite impulse response (FIR) filter.

4. The RF circuit (100) set forth in claim 2, wherein the output of the first filter (106) and the output of the second filter (110) are delivered to the selector circuit-(112) that receives the first sample data modulated signal (105) and the second sample data modulated signal (109).

5. The RF circuit (100) set forth in claim 4, wherein the first filter (106) and the second filter (110) each comprise a finite impulse response (FIR) filter.

6. The RF circuit (100) set forth in claim 5, wherein the first filter (106) comprises an 80 MSps FIR filter and the second filter (110) comprises a 160 MSps FIR filter.

7. The RF circuit (100) set forth in claim 1, wherein the RF circuit comprises a portion of an orthogonal frequency division multiplexing (OFDM) transceiver (10).

8. A method of processing signals, **characterized in that** it comprises:

creating a first sample data modulated signal (105) having a first frequency and a first sample data clock rate; up-sampling the first sample data modulated signal (105) to produce a second sample data modulated signal (109) having a second frequency and a second sample data clock rate; and selecting between the first sample data modulated signal (105) and the second sample data modulated signal (109); and

delivering one of the first sample data modulated signal (105) and the second sample data modulated signal (109) for further processing

wherein the one of the first sample data modulated signal (105) and the second sample data modulated signal (109) is selected based on a characteristic of the digital RF circuit.

9. The method set forth in claim 8, comprising filtering the first sample data modulated signal (105) and the second sample data modulated signal (109) using different filtering characteristics.

10. The method set forth in claim 8, comprising filtering the first sample data modulated signal (105) and the second sample data modulated signal (109) using finite impulse response filters (FIRs) (202, 204) having different filtering characteristics.

11. The method set forth in claim 8, wherein the recited acts are performed in the recited order.

**Patentansprüche**

1. Digitale Hochfrequenzschaltung (HF-Schaltung) (100), die ein Signal in einem gewünschten Bereich in einem Frequenzspektrum erzeugt, **dadurch gekennzeichnet, dass** die digitale Hochfrequenzschaltung umfasst:

eine Schaltung (104), die ein erstes mit Abtastdaten moduliertes Signal (105) mit einer ersten Frequenz und mit einer ersten Abtastdaten-Taktrate erzeugt;

einen Aufwärtsabtastungsmodulator (108), der das erste mit Abtastdaten modulierte Signal (105) empfängt und ein zweites mit Abtastdaten moduliertes Signal (109) mit einer zweiten Frequenz und mit einer zweiten Abtastdaten-Taktrate erzeugt; und

eine Selektorschaltung (112), die das erste mit Abtastdaten modulierte Signal (105) und das zweite mit Abtastdaten modulierte Signal (109) empfängt und das erste mit Abtastdaten modulierte Signal (105) oder das zweite mit Abtastdaten modulierte Signal (109) zur Weiterverarbeitung liefert;

wobei das erste mit Abtastdaten modulierte Signal (105) oder das zweite mit Abtastdaten modulierte Signal (109) auf der Grundlage einer Charakteristik der digitalen HF-Schaltung ausgewählt wird.

2. HF-Schaltung (100) nach Anspruch 1, die ein erstes Filter (106) mit einer ersten Filtercharakteristik, das von der Schaltung (104) das erste mit Abtastdaten modulierte Signal (105) empfängt, und ein zweites Filter (110) mit einer zweiten Filtercharakteristik, das von dem Aufwärtsabtastungsmodulator (108) das zweite mit Abtastdaten modulierte Signal (109) empfängt, umfasst.

3. HF-Schaltung (100) nach Anspruch 2, bei der das erste Filter (106) und/oder das zweite Filter (110) ein Filter mit endlicher Impulsantwort (FIR) umfasst.

4. HF-Schaltung (100) nach Anspruch 2, bei der die Ausgabe des ersten Filters (106) und die Ausgabe des zweiten Filters (110) an die Selektorschaltung (112) geliefert werden, die das erste mit Abtastdaten modulierte Signal (105) und das zweite mit Abtastdaten modulierte Signal (109) empfängt.

5. HF-Schaltung (100) nach Anspruch 4, bei der das erste Filter (106) und das zweite Filter (110) jeweils ein Filter mit endlicher Impulsantwort (FIR-Filter) umfassen.

6. HF-Schaltung (100) nach Anspruch 5, bei der das erste Filter (106) ein 80 MSps-FIR-Filter und das zweite Filter (110) ein 160 MSps-FIR-Filter umfasst.

7. HF-Schaltung (100) nach Anspruch 1, bei der die HF-Schaltung einen Abschnitt eines Orthogonalfrequenzmultiplex-Sender-Empfängers (OFDM-Sender-Empfängers) umfasst.

8. Verfahren zum Verarbeiten von Signalen, **dadurch gekennzeichnet, dass** es Folgendes umfasst:

Erzeugen eines ersten mit Abtastdaten modulierten Signals (105) mit einer ersten Frequenz und mit einer ersten Abtastdaten-Taktrate;

Aufwärtsabtasten des ersten mit Abtastdaten modulierten Signals (105) zum Erzeugen eines zweiten mit Abtastdaten modulierten Signals (109) mit einer zweiten Frequenz und mit einer zweiten Abtastdaten-Taktrate; und

Auswählen zwischen dem ersten mit Abtastdaten modulierten Signal (105) und dem zweiten mit Abtastdaten modulierten Signal (109); und

Liefern des ersten mit Abtastdaten modulierten Signals (105) oder des zweiten mit Abtastdaten modulierten Signals (109) zur Weiterverarbeitung;

wobei das erste mit Abtastdaten modulierte Signal (105) oder das zweite mit Abtastdaten modulierte Signal (109) auf der Grundlage einer Charakteristik der digitalen HF-Schaltung ausgewählt wird.

9. Verfahren nach Anspruch 8, das das Filtern des ersten mit Abtastdaten modulierten Signals (105) und des zweiten mit Abtastdaten modulierten Signals (109) unter Verwendung verschiedener Filtercharakteristiken umfasst.

10. Verfahren nach Anspruch 8, das das Filtern des ersten mit Abtastdaten modulierten Signals (105) und des zweiten mit Abtastdaten modulierten Signals (109) unter Verwendung von Filtern mit endlicher Impulsantwort (FIRs) (202, 204) mit verschiedenen Filtercharakteristiken umfasst.

11. Verfahren nach Anspruch 8, bei dem die erwähnten Vorgänge in der erwähnten Reihenfolge ausgeführt werden.

**Revendications**

1. Circuit radiofréquence (RF) numérique (100) créant un signal dans une plage souhaitée d'un spectre de fréquences, **caractérisé en ce qu'**il comprend :

   un circuit (104) produisant un premier signal modulé (105) de données échantillon ayant une première fréquence et une première fréquence d'horloge de données échantillon ;
   un modulateur suréchantillonneur (108) recevant le premier signal modulé (105) de données échantillon et produisant un second signal modulé (109) de données échantillon ayant une seconde fréquence et une seconde fréquence d'horloge de données échantillon ; et
   un circuit (112) de sélection recevant le premier signal modulé (105) de données échantillon et le second signal modulé (109) de données échantillon et fournissant un parmi le premier signal modulé (105) de données échantillon et le second signal modulé (109) de données échantillon pour un traitement supplémentaire ;

   dans lequel le signal parmi le premier signal modulé (105) de données échantillon et le second signal modulé (109) de données échantillon est sélectionné en se basant sur une caractéristique du circuit RF numérique.

2. Circuit RF (100) selon la revendication 1, comprenant un premier filtre (106) possédant des premières caractéristiques de filtre recevant le premier signal modulé (105) de données échantillon du circuit (104) et un second filtre (110) possédant des secondes caractéristiques de filtre recevant le second signal modulé (109) de données échantillon du modulateur suréchantillonneur (108).

3. Circuit RF (100) selon la revendication 2, dans lequel au moins un filtre parmi le premier filtre (106) et le second filtre (110) comprend un filtre à réponse finie (FIR).

4. Circuit RF (100) selon la revendication 2, dans lequel la sortie du premier filtre (106) et la sortie du second filtre (110) sont fournies au circuit (112) de sélection qui reçoit le premier signal modulé (105) de données échantillon et le second signal modulé (109) de données échantillon.

5. Circuit RF (100) selon la revendication 4, dans lequel le premier filtre (106) et le deuxième filtre (110) comprennent chacun un filtre à réponse finie (FIR).

6. Circuit RF (100) selon la revendication 5, dans lequel le premier filtre (106) comprend un filtre FIR de 80 MégaEchantillons par seconde et le second filtre (MSps) (110) comprend un filtre FIR de 160 MégaEchantillons par seconde.

7. Circuit RF (100) selon la revendication 1, dans lequel le circuit RF comprend une partie d'un émetteur-récepteur (10) de multiplexage par répartition orthogonale de la fréquence (OFDM).

8. Procédé de traitement de signaux, **caractérisé en ce qu'**il comprend :

   une création d'un premier signal modulé (105) de données échantillon ayant une première fréquence et une première fréquence d'horloge de données échantillon ;
   un suréchantillonnage du premier signal modulé (105) de données échantillon pour produire un second signal modulé (109) de données échantillon ayant une seconde fréquence et une seconde fréquence d'horloge de données échantillon ; et
   une sélection entre le premier signal modulé (105) de données échantillon et le second signal modulé (109) de données échantillon ; et
   une fourniture d'un signal parmi le premier signal modulé (105) de données échantillon et le second signal modulé (109) de données échantillon pour un traitement supplémentaire

   dans lequel le signal parmi le premier signal modulé (105) de données échantillon et le second signal modulé (109) de données échantillon est sélectionné en se basant sur une caractéristique du circuit RF numérique

9. Procédé selon la revendication 9, comprenant un filtrage du premier signal modulé (105) de données échantillon et du second signal modulé (109) de données échantillon à l'aide de différentes caractéristiques de filtrage.

10. Procédé selon la revendication 8, comprenant un filtrage du premier signal modulé (105) de données échantillon et du second signal modulé (109) de données échantillon à l'aide de filtres à réponse finie (FIR) (202, 204) possédant différentes caractéristiques de filtrage.

11. Procédé selon la revendication 9, dans lequel les actes cités sont réalisés dans l'ordre cité.

FIG. 1

DIGITAL
BASE BAND
OFDM
20 MSps

XMIT/RCV

Fs = 80 MSps

A/D

102

Extent_Sel

104

80 MSps
TRANSCEIVER

REAL          IMAG

DIGITAL
DEMODULATOR
OUTPUT

105

100

80 MSps          106

$\frac{X}{Sin(x)}$ FIR

109

1 to 2
UpSampler
MODULATOR

160 MSps

$\frac{X}{Sin(x)}$ FIR

110

108

112

1

0

114

D/A

"0" 160 MHz D/A
"1" 80 MHz D/A

FIG. 2

200

202

FIR

204

FIR

206

0

1

208

$Z^{-1}$

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0999645 A
- EP 0817369 A